# EUROPEAN PATENT SPECIFICATION

(11) **EP 2 450 945 B1**
(45) Date of publication and mention of the grant of the patent: **29.05.2013**
(21) Application number: 10190373.0
(22) Date of filing: 08.11.2010
(51) Int. Cl.: H01L 21/28, H01L 21/8247

(54) **Method for producing a floating gate memory structure**
Verfahren zur Herstellung einer Speicherstruktur mit Freischwebegate
Procédé de production d'une structure de mémoire à grille flottante

(43) Date of publication of application: 09.05.2012
(60) Divisional application: 13156047.6
(73) Proprietor: IMEC, 3001 Leuven (BE)
(72) Inventor: Loo, Roger, B-3010, Kessel-Lo (BE); Caymax, Matty, B-3001, Leuven (BE); Blomme, Pieter, B-8400, Oostende (BE); Van Den Bosch, Geert, B-3010, Leuven (BE)
(74) Representative: Pronovem

(56) References cited:
- US-A1- 2005 142 725
- US-A1- 2009 233 406
- US-A1- 2010 052 035
- US-A1- 2010 187 594

## Description

### Field of the Invention

The present invention is related to the production of semiconductor devices, in particular of floating gate memory devices.

### State of the art.

Though various types of floating gate nonvolatile memory devices exist, they all have in common the need to obtain a thin tunnel oxide layer on a semiconductor substrate, mostly a silicon substrate. Document US2003/0011018 for example describes a method wherein openings are made in the tunnel oxide layer and wherein monocrystalline silicon is epitaxially grown over the tunnel oxide with the openings serving as seed areas for the epi-growth. This is an example of so-called Selective Epitaxial Growth (SEG) of silicon during which the nucleation of polycrystalline Si on top of e.g. silicon nitride/oxide layers is prevented. The monocrystalline material will form the actual floating gate in the finished device.

US 2010/0052035 A1 discloses a method for producing a memory device having a single-crystal silicon floating gate electrode on a tunnel insulating film.

It is important to clean the seed areas and to remove the native oxide before the epi-growth can start. This conventional cleaning process usually comprises a wet chemical clean having a last step treatment with aqueous solutions containing hydrogen fluoride, a so-called 'HF dip'. This step causes uncontrolled thinning of said tunnel oxide leading to reproducibility issues, and possibly appearance of areas of non-uniform tunnel oxide thickness.

In flash memory devices, it is known to produce arrays of columnar floating gate structures produced from polysilicon, and having a certain thickness between parallel sidewalls. The ONO (oxide-nitride-oxide) interpoly dielectric runs along the sidewalls of the floating gate in order to provide a large capacitance between floating gate and control gate and therefore a large coupling ratio.

In order to scale the cell, it is necessary to reduce one or more of the length of the floating gate, the length of the control gate and the thickness of the interpoly dielectric. For scaled devices the length of the structures are becoming smaller and smaller and the pattern more dense. The limit of scaling would be given by a half pitch which is filled by the interpoly dielectric (on both sides). This implies that the pitch of floating gates (defined as the sum of the floating gate length and the space between two adjacent floating gates) cannot be scaled below a value which corresponds to the sum of the floating gate (FG) length (scalable to about 5nm), the control gate (CG) length (scalable to about 5nm) and two times the ONO interpoly (IPD) thickness (scalable to about 15nm). This gives a total sum of about 40nm and therefore a limit of scaling of 20nm half pitch (i.e. half-pitch below 20nm is difficult to achieve). A solution for this is to make a thinner vertical inter-poly dielectric, but this is not trivial for the ONO (oxide-nitride-oxide) stacks in use.

### Summary of the invention

The invention provides a solution to the problems mentioned above. It is related to methods as described in the appended claims. The invention is related to a method for producing a floating gate memory device, comprising steps to improve the control of the thickness of the tunnel oxide layer.

The invention is related to a method for producing a floating gate memory device comprising the steps of :
- Providing a monocrystalline semiconductor substrate,
- Forming a tunnel oxide layer on said substrate,
- Depositing a protective layer on said tunnel oxide layer, thereby forming a stack of the tunnel oxide and the protective layer on the substrate,
- Producing one or more openings in said stack, to expose areas of said semiconductor substrate,
- Cleaning the exposed substrate with a cleaning liquid, wherein said protective layer is substantially not removed by said cleaning liquid,
- Loading the substrate into an epitaxial reactor, and thereafter
- Optionally, annealing the substrate, to thereby remove any remaining oxides from the areas,
- Removing the protective layer, by an in-situ etching process, wherein the protective layer is etched selectively with respect to the tunnel oxide layer,
- Epitaxially growing a monocrystalline semiconductor layer on the substrate by selective epitaxial growth using the exposed substrate areas as source areas,
- Forming said monocrystalline layer into one or more columnar floating gate structures.

According to a preferred embodiment, said semiconductor material is silicon, said tunnel oxide layer is a thermally grown SiO₂ layer, and said protective layer is an amorphous Si layer or a polycrystalline Si layer.

According to an embodiment, said semiconductor material is silicon, said cleaning liquid comprises hydrogen fluoride (HF) and said in-situ etching process is performed by exposing the substrate to a halogen containing precursor, preferably HCl or Cl₂.

According to a preferred embodiment, the selectivity of the etching process for etching the protective layer versus etching the tunnel oxide layer is 100:1 or more.

In the method according to the invention, the step of forming said monocrystalline layer into one or more columnar floating gate structures may comprise the following substeps :
- Planarizing the monocrystalline semiconductor layer,
- Depositing a hard mask layer made of dielectric material on the planarized monocrystalline layer,
- Depositing and patterning a layer of resist on the hard mask layer,
- Etching the hard mask layer and the monocrystalline layer, stopping on the tunnel oxide layer, thereby forming columnar monocrystalline floating gate structures wherein the hard mask is left on top of the columnar structures,
- Etching trenches between said columnar floating gate structures, through the portions of the tunnel oxide layer situated between the columnar floating gate structures,
- Filling said trenches with a dielectric material, leaving a portion of the columnar floating gate structures exposed,
- Thermally growing an oxide layer on each of the lateral sides of the columnar floating gate structures, and thereafter :
- Depositing a control gate layer between and on top of said columnar floating gate structures.

In a preferred embodiment of the method according to the invention, the thickness of said thermally grown oxide layer on the lateral sides of said floating gate structures is between 5nm and 15nm, more preferably between 5nm and 10nm, more preferably between 6nm and 8nm.

Furthermore, the half pitch between adjacent columnar floating gate structures may be between 10nm and 20nm, more preferably between 10nm and 15nm, more preferably between 11nm and 13nm.

### Brief description of the figures

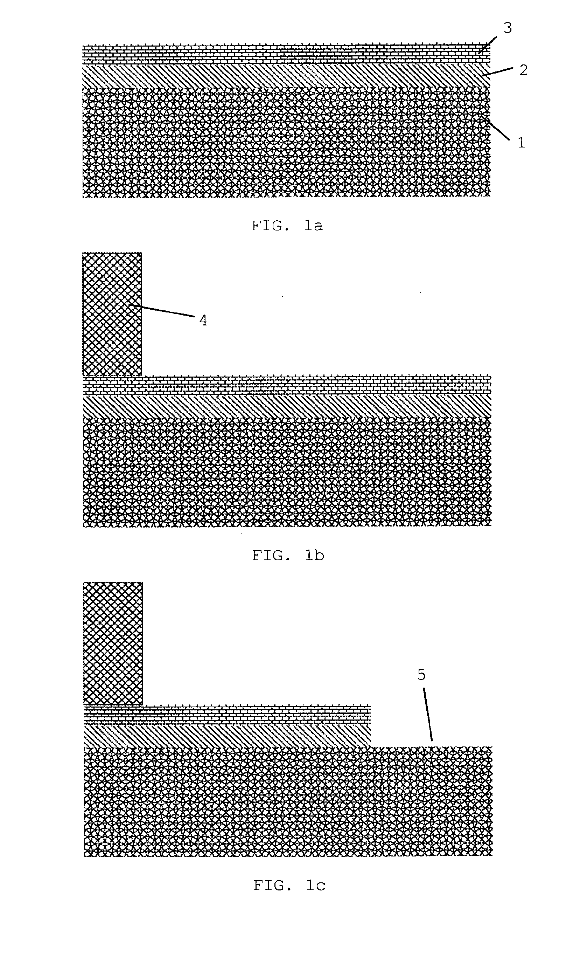

Figures 1a to 1m illustrate the process flow of the fabrication of a floating gate memory device according to the method of the invention.

### Detailed description of the invention

With reference to figures 1a to 1m, the method according to the invention is illustrated. The invention is not limited to the method shown in these drawings, but is applicable to the fabrication of any type of floating gate memory device.

In a first step (fig. 1a) , a monocrystalline silicon substrate 1 is provided, and a tunnel oxide layer 2 is produced onto said substrate. This is a thin layer of SiO₂ preferably obtained by thermal oxidation of the substrate. The tunnel oxide thickness is of the order of 5-10nm.

In a step which is characteristic to the invention, a protection layer 3 is then deposited, for example by Chemical Vapour Deposition (CVD) onto the tunnel oxide layer 2. This protection layer can be a layer of amorphous Si. Alternatively, it can be a polycrystalline Si layer. The thickness of this layer can be a few nm, in any case the thickness must be sufficient to cover the complete tunnel oxide layer, and to maintain said complete coverage during the subsequent wet chemical cleaning step.

Then stopping structures 4 are produced on the amorphous silicon layer (fig. 1b). These structures (only one shown) are configured to stop a chemical mechanical polishing operation (CMP). According to a preferred embodiment, these stopping structures are silicon nitride (Si₃N₄) stoppers obtained by depositing a layer of Si₃N₄ and then patterning said layer to define protrusions which act as CMP stoppers. Advantageously during the epitaxial growth silicon does not nucleate on the stoppers made of stoichiometric Si₃N₄.

Alternatively, the stoppers may be produced directly onto the substrate 1, before production of the tunnel oxide layer 2 and protective layer 3, said layers being deposited conformally onto the substrate 1 and onto the stoppers 4.

Then openings are etched in the stack of tunnel oxide 2 and amorphous Si layer 3, by a known litho and dry etch process (fig. 1c) followed by a post-etch wet clean (strip) process, to thereby expose the Si-substrate in areas 5 (only one shown).

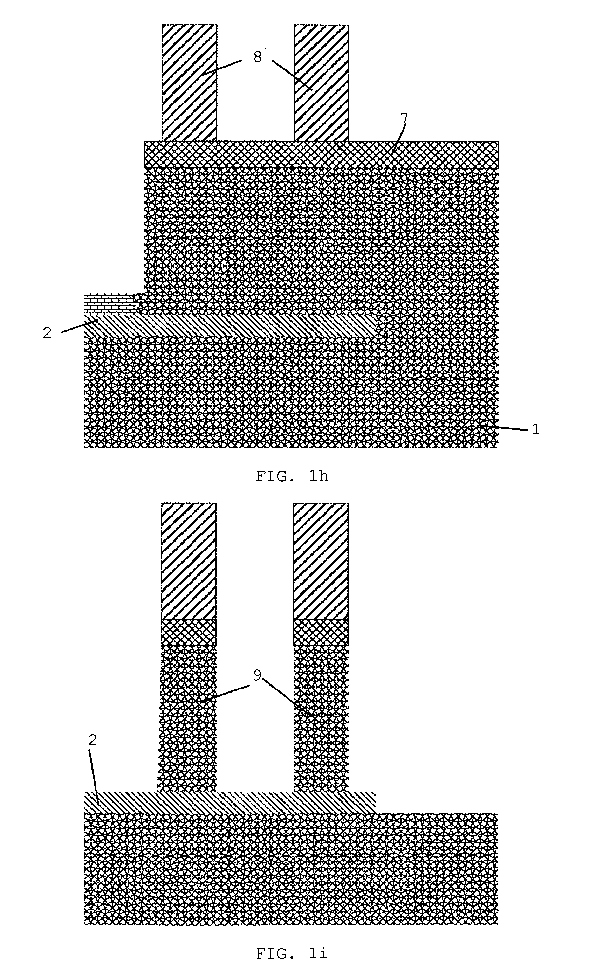

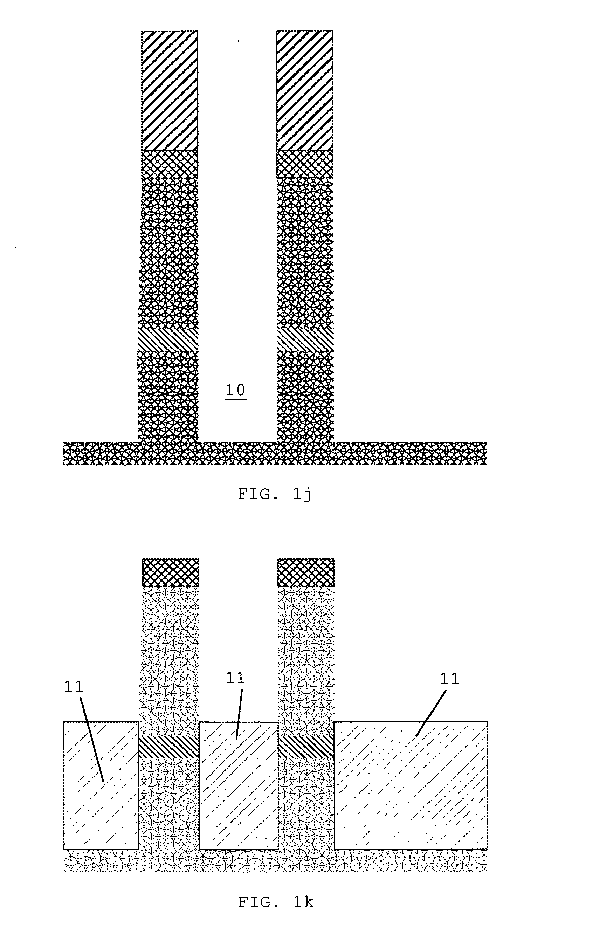

After litho, etch and post-etch strip, these areas 5 are covered by a native oxide layer, which is removed in the next process step by a wet chemical clean, preferably an HF dip. Advantageously, the protective layer 3 protects the tunnel oxide layer during this HF dip, so that the tunnel oxide layer thickness remains unaltered in the area where the floating gate structures will be produced. It is possible that at the lateral sides of the areas 5, the tunnel oxide layer is slightly etched during the wet chemical cleaning step. However, at the future locations of the floating gate structures (see fig. 1i and 1j), the thickness of the tunnel oxide is maintained. This represents a major improvement over the state of the art.

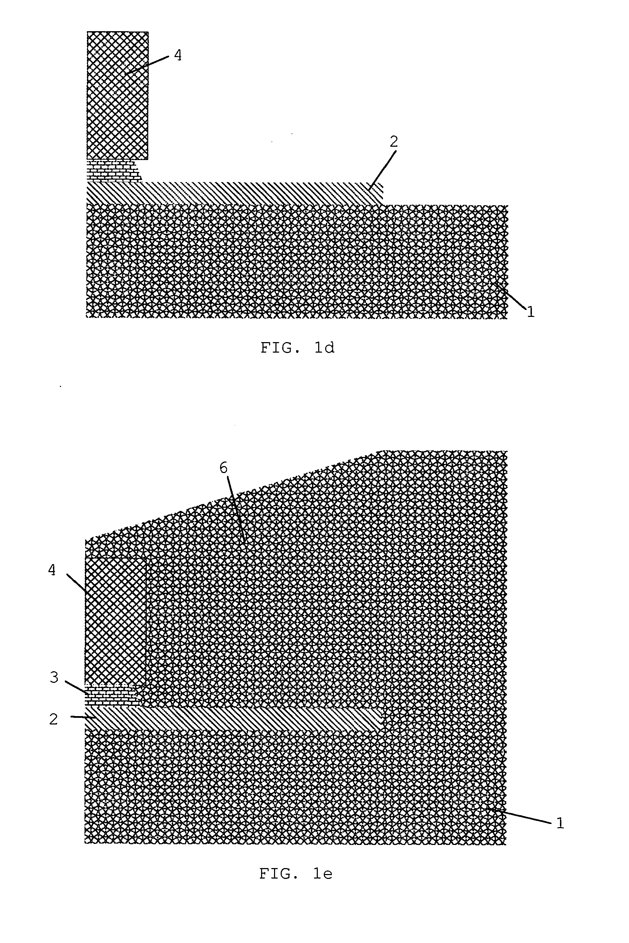

Then the substrate is preferably moved into the reactor for epitaxial Si-growth, where the next steps are performed in-situ. Possibly, a pre-epi baking step is performed at a temperature between 600°C and 1050°C, typically at 850°C. The primary aim of this pre-epi baking step is to remove any oxides from the areas 5 which may have been formed during transition from the wetcleaning installation to the epi-reactor. If an amorphous Si layer is used as the protective layer, the amorphous silicon transforms into poly-silicon during the pre-epi baking step. Then the protective layer is removed selectively with respect to the underlying tunnel oxide by in-situ etching with HCl-containing precursors at a temperature between 600°C and 1000°C, preferably at about 850°C (fig. 1d). Alternatively, no pre-epi bake is done and the protective layer 3 is removed selectively with respect to the underlying tunnel oxide by the in-situ HCl treatment at the same temperature between 600°C and 1000°C, preferably at about 850°C. This step is not limited to a HCI etching step but could be done in the presence of other halogen-based precursors, e.g. Cl₂. Preferably, the selectivity of the etching process for etching the protective layer versus etching the tunnel oxide is 100:1 or more. The selectivity of the etching process for etching the protective layer versus monocrystalline silicon is less critical. It is preferably 10:1 or more, so that not more than a limited amount of monocrystalline Si is etched in the areas 5 during this step. However, even when more monocrystalline Si is etched (even when there is no selectivity), the result is satisfactory, given that an oxide-free surface of monocrystalline Si is obtained in the areas 5, on which further monocrystalline Si can be grown by SEG.

After this, the SEG step is done (fig. 1e), to form a laterally overgrowing monocrystalline Si-layer 6 starting from the areas 5, and extending over the tunnel oxide to a thickness above the height of the CMP-stoppers 4. Preferably, the CMP stoppers 4 are formed in between areas 5, so that two overgrowing epitaxial Si-layers, originating from two adjacent areas 5 come into mutual contact in the space above the CMP stop situated between the two areas 5. In this way, the border area between the two monocrystalline layers is at a safe distance from the substrate regions on either side of the stoppers. Such border areas are bound to contain irregularities in terms of the crystal structure.

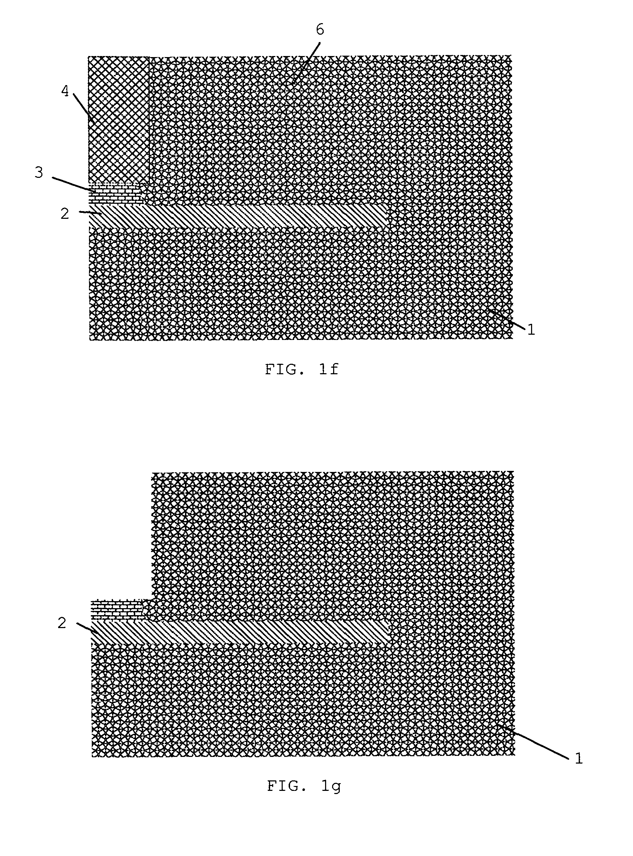

This is followed by a CMP step, to planarize the monocrystalline Si-layer (fig. 1f), and subsequently by the removal of the CMP stoppers, e.g. by a selective wet etch of the silicon nitride stoppers (fig. 1g)

By the further steps (figs 1h to 1m), columnar floating gate structures are produced. After CMP a hard mask layer 7 comprising or consisting of a dielectric material (e.g. SiN or SiO₂) is deposited on top of the monocrystalline Si 6 as shown in Figure 1h. A resist layer 8 is patterned on top of the hard mask layer. Further, a plurality of columnar floating gate structures 9 are patterned by etching the stack comprising the hard mask layer 7 and the mono-crystalline Si material 6 and stopping on the tunnel oxide as shown in Figure 1i. The patterned structure has a half pitch between 10nm and 20nm, preferably between 11 and 13nm.

As shown in Figure 1j the tunnel oxide and the underlying substrate (monocrystalline Si) is etched further to form trenches 10 with a depth of about 300 to 350nm. In a next step (Figure 1k) shallow trench isolation (STI) regions 11 are formed by filling the trenches 10 with an insulating material (preferably silicon oxide). The STI oxide fills the trenches to a height just above the tunnel oxide 2, but leaves the largest part of the floating gate structures 9 exposed.

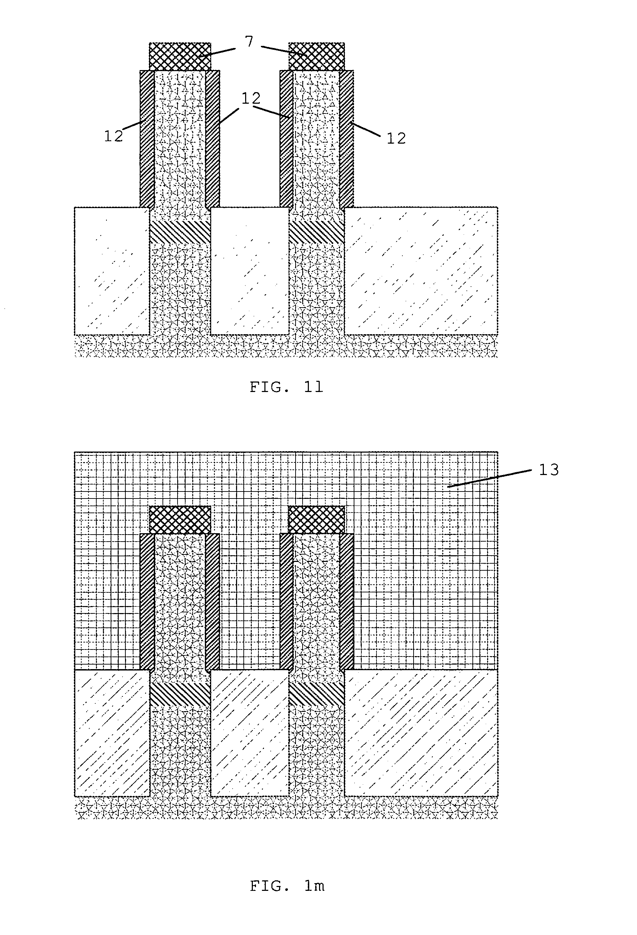

In a next step (Figure1l) an SiO₂ layer 12 is formed on the sidewalls of the floating gate structures 9 by thermal oxidation of the monocrystalline silicon the floating gate is made of. In this way a very thin layer (between 5nm and 15nm, preferably between 5 and 10 nm, more preferably between 6 and 8nm of high quality thermal oxide is formed on the sidewalls of the floating gate structures with a half pitch of 10-20nm, preferably 10-15nm, more preferably 11-13nm. The above numbers for the half pitch are based on the floating gate structures having a length (thickness) of 5nm, and the control gate structures (fig. 1m) have also a length of 5nm.

Advantageously the hard mask layer 7 is kept on top of the floating gate structures preventing unwanted leakage between the top surface of the floating gate or the top corners of the floating gate and the control gate 13. Preferably, the hard mask layer 7 left on top of the floating gate structures acts as top inter-poly dielectric in between the mono-crystalline floating gate and the control gate. Advantageously, the thickness of the hard mask layer (7) is higher than the thickness of the thermally grown SiO₂ layers 12 (preferably about 5-15nm thicker).

Further a control gate (CG) (13) is formed by depositing (e.g. by CVD) a polysilicon material completely surrounding the floating gate structures having the thermally grown SiO₂ layers 12 formed on the sidewalls as shown in Figure 1m.

The above method steps lead to a dense pattern of columnar floating gates in mono-crystalline Si and provided with a thermal oxide on both sides. Following the method of the invention a half pitch of 11-13 nm can be achieved, due to the low thickness at which a thermally grown SiO₂ layer can be produced on the sidewalls of the floating gate structures. This half pitch would not be possible with an ONO interpoly dielectric thickness.

The resulting structure obtained by the invention is operated like a normal NAND memory array (see e.g. "Nonvolatile memory technologies with emphasis on Flash", Wiley-Interscience 2007, p.227-237 ISBN 978-0471-77002-2) after patterning the control gates and the floating gates in a direction perpendicular to the direction of the STI regions. Every floating gate is at the intersection of a region of the substrate where STI regions 11 are not formed, which acts as the NAND string, and of a control gate, which acts as the wordline of the memory array.

## Claims

1. A method for producing a floating gate memory device comprising the steps of :
• Providing a monocrystalline semiconductor substrate (1),
• Forming a tunnel oxide layer (2) on said substrate,
• Depositing a protective layer (3) on said tunnel oxide layer, thereby forming a stack of the tunnel oxide (2) and the protective layer (3) on the substrate,
• Producing one or more openings in said stack, to expose areas (5) of said semiconductor substrate,
• Cleaning the exposed substrate with a cleaning liquid, wherein said protective layer (3) is substantially not removed by said cleaning liquid,
• Loading the substrate into an epitaxial reactor, and thereafter
• Optionally, annealing the substrate, to thereby remove any remaining oxides from the areas (5),
• Removing the protective layer (3), by an in-situ etching process, wherein the protective layer (3) is etched selectively with respect to the tunnel oxide layer (2),
• Epitaxially growing a monocrystalline semiconductor layer (6) on the substrate by selective epitaxial growth using the exposed substrate areas (5) as source areas,
• Forming said monocrystalline layer (6) into one or more columnar floating gate structures.

2. Method according to claim 1, wherein said semiconductor material is silicon, and wherein said tunnel oxide layer (2) is a thermally grown SiO₂ layer, and wherein said protective layer (3) is an amorphous Si layer or a polycrystalline Si layer.

3. Method according to claim 1 or 2, wherein said semiconductor material is silicon, said cleaning liquid comprises hydrogen fluoride (HF) and said in-situ etching process is performed by exposing the substrate to a halogen containing precursor.

4. Method according to claim 3, wherein said halogen-containing precursor is HCl or Cl₂.

5. Method according to any one of the preceding claims, wherein the selectivity of the etching process for etching the protective layer versus etching the tunnel oxide layer is 100:1 or more.

6. Method according to any one of the preceding claims, wherein the step of forming said monocrystalline layer (6) into one or more columnar floating gate structures comprises the following substeps :
• Planarizing the monocrystalline semiconductor layer (6),
• Depositing a hard mask layer (7) made of dielectric material on the planarized monocrystalline layer (6),
• Depositing and patterning a layer of resist (8) on the hard mask layer (7),
• Etching the hard mask layer (7) and the monocrystalline layer (6), stopping on the tunnel oxide layer (2), thereby forming columnar monocrystalline floating gate structures (9) wherein the hard mask is left on top of the columnar structures (9),
• Etching trenches (10) between said columnar floating gate structures (9), through the portions of the tunnel oxide layer (2) situated between the columnar floating gate structures (9),
• Filling said trenches with a dielectric material (11), leaving a portion of the columnar floating gate structures (9) exposed,
• Thermally growing an oxide (12) layer on each of the lateral sides of the columnar floating gate structures (9), and thereafter :
• Depositing a control gate layer (13) between and on top of said columnar floating gate structures (9).

7. Method according to claim 6, wherein the thickness of said thermally grown oxide layer (12) on the lateral sides of said floating gate structures (9) is between 5nm and 15nm, more preferably between 5nm and 10nm, more preferably between 6nm and 8nm.

8. Method according to claim 7, wherein the half pitch between adjacent columnar floating gate structures (9) is between 10nm and 20nm, more preferably between 10nm and 15nm, more preferably between 11nm and 13nm.

## Patentansprüche

1. Verfahren zum Herstellen einer Floating-Gate-Speichereinheit, das die folgenden Schritte umfasst:
• Bereitstellen eines monokristallinen Halbleitersubstrats (1);
• Bilden einer Tunneloxidschicht (2) am Substrat;
• Ablagern einer Schutzschicht (3) auf der Tunneloxidschicht, wodurch ein Stapel aus dem Tunneloxid (2) und der Schutzschicht (3) am Substrat gebildet wird,
• Bilden einer oder mehrerer Öffnungen in dem Stapel, um Bereiche (5) des Halbleitersubstrats freizulegen,
• Reinigen des freigelegten Substrats mit einer Reinigungsflüssigkeit, wobei die Schutzschicht (3) durch die Reinigungsflüssigkeit im Wesentlichen nicht entfernt wird,
• Laden des Substrats in einen epitaktischen Reaktor und danach
• optionales Glühen des Substrats, um dadurch restliche Oxide aus den Bereichen (5) zu entfernen,
• Entfernen der Schutzschicht (3) mithilfe eines In-situ-Ätzverfahrens, wobei die Schutzschicht (3) selektiv in Bezug auf die Tunneloxidschicht (2) geätzt wird,
• epitaktisches Züchten einer monokristallinen Halbleiterschicht (6) auf dem Substrat durch selektives epitaktisches Züchten unter Verwendung der freigelegten Substratbereiche (5) als Quellbereiche,
• Bilden der monokristallinen Schicht (6) in eine oder mehrere säulenförmige Floating-Gate-Strukturen.

2. Verfahren nach Anspruch 1, wobei das Halbleitermaterial Silicium ist, und wobei die Tunneloxidschicht (2) eine thermisch gezüchtete SiO₂-Schicht ist, und wobei die Schutzschicht (3) eine amorphe Si-Schicht oder eine polykristalline Si-Schicht ist.

3. Verfahren nach Anspruch 1 oder 2, wobei das Halbleitermaterial Silicium ist, wobei die Reinigungsflüssigkeit Wasserstofffluorid (HF) umfasst, und wobei das In-situ-Ätzverfahren durch Aussetzen des Substrats gegenüber einem halogenhaltigen Vorläufer durchgeführt wird.

4. Verfahren nach Anspruch 3, wobei der halogenhaltige Vorläufer HCl oder Cl₂ ist.

5. Verfahren nach einem der vorstehenden Ansprüche, wobei die Selektivität des Ätzverfahrens zum Ätzen der Schutzschicht gegenüber dem Ätzen der Tunneloxidschicht 100:1 oder mehr ist.

6. Verfahren nach einem der vorstehenden Ansprüche, wobei der Schritt des Bildens der monokristallinen Schicht (6) in eine oder mehrere säulenförmige Floating-Gate-Strukturen die folgenden Teilschritte umfasst:
• Planarisieren der monokristallinen Halbleiterschicht (6),
• Ablagern einer Hartmaskenschicht (7), die aus einem dielektrischen Material hergestellt ist, auf der planarisierten monokristallinen Schicht (6),
• Ablagern und Strukturieren einer Schutzschicht (8) auf der Hartmaskenschicht (7),
• Ätzen der Hartmaskenschicht (7) und der monokristallinen Schicht (6), wobei auf der Tunneloxidschicht (2) gestoppt wird, um dadurch säulenförmige monokristallen Floating-Gate-Strukturen (9) zu bilden, wobei die Hartmaske oben auf den säulenförmigen Strukturen (9) zurückgelassen wird,
• Ätzen von Gräben (10) zwischen den säulenförmigen Floating-Gate-Strukturen (9) durch die Abschnitte der Tunneloxidschicht (2), die zwischen den säulenförmigen Floating-Gate-Strukturen (9) angeordnet sind,
• Füllen der Gräben mit einem dielektrischen Material (11), wobei ein Abschnitt der säulenförmigen Floating-Gate-Strukturen (9) freigelegt bleibt,
• thermisches Züchten einer Oxidschicht (12) auf jeder der lateralen Seiten der säulenförmigen Floating-Gate-Strukturen (9) und danach:
• Ablagern einer Control-Gate-Schicht (13) zwischen und oben auf den säulenförmigen Floating-Gate-Strukturen (9).

7. Verfahren nach Anspruch 6, wobei die Dicke der thermisch gezüchteten Oxidschicht (12) auf den lateralen Seiten der Floating-Gate-Strukturen (9) zwischen 5 nm und 15 nm beträgt, vorzugsweise zwischen 5 nm und 10 nm, mehr bevorzugt zwischen 6 nm und 8 nm.

8. Verfahren nach Anspruch 7, wobei der Half-Pitch zwischen benachbarten säulenförmigen Floating-Gate-Strukturen (9) zwischen 10 nm und 20 nm beträgt, vorzugsweise zwischen 10 nm und 15 nm, mehr bevorzugt zwischen 11 nm und 13 nm.

## Revendications

1. Procédé pour produire un dispositif de mémoire à grille flottante, comprenant les étapes consistant à :
• disposer d'un substrat semi-conducteur monocristallin (1),
• former une couche d'oxyde de tunnel (2) sur ledit substrat,
• déposer une couche protectrice (3) sur ladite couche d'oxyde de tunnel, en formant ainsi un empilement de l'oxyde de tunnel (2) et de la couche protectrice (3) sur le substrat,
• produire une ou plusieurs ouvertures dans ledit empilement, pour exposer des zones (5) dudit substrat semi-conducteur,
• nettoyer le substrat exposé avec un liquide nettoyant, ladite couche protectrice (3) n'étant pratiquement pas éliminée par ledit liquide nettoyant,
• charger le substrat dans un réacteur épitaxial, et
ensuite
• éventuellement recuire le substrat pour éliminer ainsi tous les oxydes restants dans les zones (5),
• retirer la couche protectrice (3), par un procédé de gravure in situ, la couche protectrice (3) étant gravée sélectivement par rapport à la couche d'oxyde de tunnel (2),
• faire croître par croissance épitaxiale une couche de semi-conducteur monocristallin (6) sur le substrat par croissance épitaxiale sélective utilisant les zones de substrat exposées (5) en tant que zones de source,
• mettre ladite couche monocristalline (6) sous la forme d'une ou plusieurs structures de grille flottante en colonnes.

2. Procédé selon la revendication 1, dans lequel ledit matériau semi-conducteur est le silicium, et dans lequel ladite couche d'oxyde de tunnel (2) est une couche de SiO₂ ayant crû thermiquement, et dans lequel ladite couche protectrice (3) est une couche de Si amorphe ou une couche de Si polycristallin.

3. Procédé selon la revendication 1 ou 2, dans lequel ledit matériau semi-conducteur est le silicium, ledit liquide nettoyant comprend du fluorure d'hydrogène (HF) et ledit procédé de gravure in situ est effectué par exposition du substrat à un précurseur halogéné.

4. Procédé selon la revendication 3, dans lequel ledit précurseur contenant un halogène est HCl ou Cl₂.

5. Procédé selon l'une quelconque des revendications précédentes, dans lequel la sélectivité du procédé de gravure pour graver la couche protectrice vis-à-vis de la gravure de la couche d'oxyde de tunnel est de 100/1 ou plus.

6. Procédé selon l'une quelconque des revendications précédentes, dans lequel l'étape de mise de ladite couche monocristalline (6) sous la forme d'une ou plusieurs structures de grille flottante en colonnes comprend les sous-étapes suivantes :
• planarisation de la couche de semi-conducteur monocristallin (6),
• dépôt d'une couche de masque dure (7) faite en un matériau diélectrique sur la couche monocristalline planarisée (6),
• dépôt et formation d'un motif d'une couche de réserve (8) sur la couche de masque dure (7),
• gravure de la couche de masque dure (7) et de la couche monocristalline (6), qui s'arrête sur la couche d'oxyde de tunnel (2), ce qui forme ainsi des structures de grille flottante monocristallines en colonnes (9), le masque dur étant laissé sur le dessus des structures en colonnes (9),
• gravure de tranchées (10) entre lesdites structures de grille flottante en colonnes (9), à travers les portions de la couche d'oxyde de tunnel (2) se trouvant entre les structures de grille flottante en colonnes (9),
• remplissage desdites tranchées avec un matériau diélectrique (11), en laissant exposée une portion des structures de grille flottante en colonnes (9),
• croissance thermique d'une couche d'oxyde (12) sur chacun des côtés latéraux des structures de grille flottante en colonnes (9), et ensuite :
• dépôt d'une couche de grille de contrôle (13) entre et sur le dessus desdites structures de grille flottante en colonnes (9).

7. Procédé selon la revendication 6, dans lequel l'épaisseur de ladite couche d'oxyde ayant crû thermiquement (12) sur les côtés latéraux desdites structures de grille flottante (9) est comprise entre 5 nm et 15 nm, de préférence entre 5 nm et 10 nm, mieux encore entre 6 nm et 8 nm.

8. Procédé selon la revendication 7, dans lequel le demi-pas entre des structures de grille flottante en colonnes adjacentes (9) est compris entre 10 nm et 20 nm, de préférence entre 10 nm et 15 nm, mieux encore entre 11 nm et 13 nm.
